# EUROPÄISCHE PATENTSCHRIFT

(11) **EP 3 355 474 B1**
(45) Veröffentlichungstag und Bekanntmachung des Hinweises auf die Patenterteilung: **08.12.2021**
(21) Anmeldenummer: 17153284.9
(22) Anmeldetag: 26.01.2017
(51) Int. Cl.: H03K 17/975, G06F 3/02, G06F 3/0354, G06F 3/0362, G06F 3/039

(54) **SCHALT-VORRICHTUNG ZUR UMWANDLUNG EINER MANUELLEN UND/ODER MECHANISCHEN BEWEGUNG IN EIN SCHALTSIGNAL**
SWITCHING DEVICE FOR CONVERTING A MANUAL AND/OR MECHANICAL MOTION INTO A SWITCHING SIGNAL
DISPOSITIF DE COMMUTATION DESTINÉ À LA CONVERSION D'UN MOUVEMENT MÉCANIQUE ET/OU MANUEL EN UN SIGNAL DE COMMUTATION

(43) Veröffentlichungstag der Anmeldung: 01.08.2018
(60) Teilanmeldung: 20168698.7
(73) Patentinhaber: RAFI GmbH & Co. KG, 88276 Berg (DE)
(72) Erfinder: Bulach, Dipl.-Ing. Eric, 88074 Meckenbeuren (DE); Fleischer, Frank, 88368 Bergatreute (DE); Wahl, Simon, 88410 Bad Wurzach (DE); Mennig, Sebastian, 88353 Kißlegg (DE); Hofmann, Steffen, 88364 Wolfegg (DE)
(74) Vertreter: Engelhardt, Volker

(56) Entgegenhaltungen:
- WO-A1-2006/036950
- DE-A1-102009 032 634

## Beschreibung

Die Erfindung bezieht sich auf eine Schalt-Vorrichtung mit mehreren Schaltstufen zur Umwandlung einer manuellen und/oder mechanischen Zustellbewegung in ein mindestens elektrisches Schaltsignal, durch das ein elektrisches Gerät gesteuert ist, nach dem Oberbegriff des Patentanspruchs 1.

Aus der DE 10 2015 115 248 kann eine derartige Schalt-Vorrichtung entnommen werden, die eine Zustellbewegung in ein entsprechendes elektrisches Schaltsignal umwandelt. Die Schalt-Vorrichtung besteht aus einer ringförmigen Fassung, in der ein elektrisch nichtleitfähiges Tastenteil mit einem Metallkern angeordnet ist, das Mittels einer Federeinrichtung in einer Ausgangsposition gehalten ist. Bei einer entsprechenden manuellen Betätigung der Schalt-Vorrichtung ist das Tastenteil mit dem Metallkern in Richtung einer Abdeckplatte bewegt, hinter der sich eine Sensorelektrode befindet, die die Annäherung des Metallkerns des Tastenteils registriert.

Der DE 10 2009 032 634 A1 ist eine Schalt-Vorrichtung zur Umwandlung einer manuellen und/oder mechanischen Zustellbewegung in mindestens ein Schaltsignal zu entnehmen, durch die ein elektrisches Gerät gesteuert ist. Zu diesem Zweck weist diese Schalt-Vorrichtung verschiedene mechanische und elektrische Bauteile auf.

Nachteiliger Weise sind diese mechanischen und elektrischen Bauteile sind fest angeordnet, sodass die durch diesen Stand der Technik zu lösende erfindungsgemäße Aufgabe nicht gelöst werden kann.

Bei einer derartigen Schalt-Vorrichtung handelt es sich um eine Bedien-Vorrichtung bzw. Mensch-Maschine-Schnittstelle, die typischerweise auf einer Abdeckplatte eines berührungssensitiven Bildschirms, auch Touchscreens genannt, angeordnet ist. Die Abdeckplatte des berührungssensitiven Bildschirms ist aus einem transparenten und elektrisch nichtleitfähigen Material hergestellt. Eine Vielzahl von paarweise angeordneten Elektroden bilden einen kapazitiven Flächensensor, der auf die Annäherung oder Berührung eines Gegenstandes, beispielsweise Finger, Hand oder dergleichen, anspricht. Die dabei entstehenden Schaltsignale werden elektronisch verstärkt und zur Steuerung eines elektrischen Gerätes verwendet.

Nachteilig an dieser Schaltvorrichtung ist, dass diese einerseits keine taktile Rückmeldung erzeugt und andererseits, dass eine derartige Schalt-Vorrichtung lediglich ein Schaltsignal generieren kann.

Es ist daher Aufgabe der Erfindung, eine Schalt-Vorrichtung der eingangs genannten Gattung derart weiterzubilden, dass durch diese ein mehrstufiges Schaltsignal in Form eines kapazitiven Berühr- und Drucktasters generiert und auswertbar ist und darüber hinaus soll bei der Betätigung eine taktile Rückmeldung erzeugt werden, durch die der Benutzer erkennt, ob und welche Betätigung gewünscht ist.

Die Aufgabe ist erfindungsgemäß durch die Merkmale des kennzeichnen Teils von Patentanspruch 1 gelöst.

Weitere vorteilhafte Weiterbildungen der Erfindung ergeben sich aus den Unteransprüchen.

Dadurch, dass durch das Betätigungselement das erste elektrische Schaltsignal bei einer Berührung der Bedienkappe mithilfe des kapazitiven Flächensensors generiert ist und dass bei einer Zustellbewegung der Bedienkappe mindestens ein zweites differenzierbares elektrisches Schaltsignal mithilfe des kapazitiven Flächensensors gebildet ist, dass zwischen der Bedienkappe und dem kapazitiven Flächensensor mindestens eine elektrisch leifähige Kontaktplatte angeordnet ist, die elektrisch isoliert von dem Betätigungselement ist, dass bei einer Zustellbewegung der Bedienkappe diese mit mindestens einer der Kontaktplatten kurzgeschlossen ist und dass die Bedienkappe mittels der jeweiligen Kontaktplatte mit dem kapazitiven Flächensensor kapazitiv gekoppelt ist, entsteht ein mehrstufiges und differenzierbares Schaltsignal. Aufgrund der kapazitiven Kopplung zwischen der Bedienkappe und dem Flächensensor ist bereits die Berührung des Gegenstandes, beispielsweise durch einen Finger oder eine Hand, mit der Bedienkappe durch den kapazitiven Flächensensor erfasst und ein elektrisches Schaltsignal wird generiert. Zur Erzeugung des zweiten Schaltsignals ist die Bedienkappe hubartig gedrückt und in Richtung des kapazitiven Flächensensors zugestellt. Das Betätigungselement, das zwischen der Bedienkappe und dem kapazitiven Flächensensor angeordnet ist, wird dadurch elastisch verformt. Der kapazitive Flächensensor erfasst diese Veränderung und kontaktiert eine elektrisch leitfähige Kontaktplatte.

Zwischen der Bedienkappe und dem kapazitiven Flächensensor kann eine elektrisch leitfähige Kontaktplatte angeordnet sein. Die Kontaktplatte ist elektrisch isoliert von dem Betätigungselement und der Bedienkappe im unbetätigten Zustand angeordnet. Bei einer Betätigung der Bedienkappe ist die Bedienkappe mit der Kontaktplatte kurzgeschlossen, so dass die Bedienkappe mittels der Kontaktplatte mit dem kapazitiven Flächensensor kapazitiv gekoppelt ist. Die Kontaktplatte bildet somit nach Art eines Endanschlages die Endposition der Bedienkappe bei der Betätigung. Aufgrund der isolierten Anordnung der Kontaktplatte ist das zweite Schaltsignal ausschließlich bei dem Kurzschluss zwischen der Bedienkappe und der Kontaktplatte generiert. An dem Loslassen der Bedienkappe federt diese durch das Betätigungselement in die Ausgangsposition zurück.

Darüber hinaus ist besonders vorteilhaft, wenn die Anzahl und/oder die Intensität der durch das Betätigungselement betätigten Elektroden bzw. Elektrodenpaaren des kapazitiven Flächensensors und/oder deren Messwerte die das erste elektrische, das zweite elektrische Schaltsignal und das dritte Schaltsignal generieren, unterschiedlich sind. Ein mehrstufiges Schaltsignal zeichnet sich dadurch aus, dass in Abhängigkeit von der Intensität der Bedienung bzw. dem Tastenhub mehrere voneinander unabhängige und differenzierbare Schaltsignale generiert sind.

Das Schaltgehäuse kann auf einer Abdeckplatte eines elektrischen Gerätes angeordnet sein. Hierzu kann das Schaltgehäuse auf die Abdeckplatte geklebt, geschweißt, geschraubt oder auf sonstige Weise lagestabil arretiert werden. Der kapazitive Flächensensor kann auf der dem Schaltgehäuse abgewandten oder auf der dem Schaltgehäuse zugewandten Seite der Abdeckplatte angeordnet sein. Weiterhin kann auf der dem Schaltgehäuse abgewandten Seite der Abdeckplatte eine Anzeigevorrichtung oder einer Grafik angeordnet sein.

In der Zeichnung ist ein erfindungsgemäßes Ausführungsbeispiel einer Schalt-Vorrichtung dargestellt, die nachfolgend näher erläutert ist. Im Einzelnen zeigt:
- Figur 1a: eine Schalt-Vorrichtung im unbetätigten Zustand, durch die ein mehrstufiges Schaltsignal zur Steuerung eines elektrischen Gerätes generiert ist, mit einem Schaltgehäuse, in das eine Aufnahmeöffnung eingearbeitet ist, einer Abdeckplatte, die aus einem elektrisch leitfähigen Werkstoffen hergestellt und in der Aufnahmeöffnung des Schaltgehäuses axial beweglich gelagert ist, einem als Schnappscheibe ausgeformten Betätigungselement,
- Figur 1b: die Schalt-Vorrichtung gemäß Figur 1a im betätigten Zustand,
- Figur 1c: die Bestandteile der Schalt-Vorrichtung gemäß Figur 1a in einer Explosions-Darstellung,
- Figur 2a: eine Weiterbildung der Schalt-Vorrichtung gemäß Figur 1a mit drei Schaltstufen,
- Figur 2b: die Schalt-Vorrichtung gemäß Figur 2a im betätigten Zustand bei dem Erreichen der zweiten Schaltstufe,
- Figur 2c: die Schalt-Vorrichtung gemäß Figur 2a bei dem Erreichen der dritten Schaltstufe,
- Figur 3: der Signalverlauf der Schalt-Vorrichtung gemäß Figur 2a.

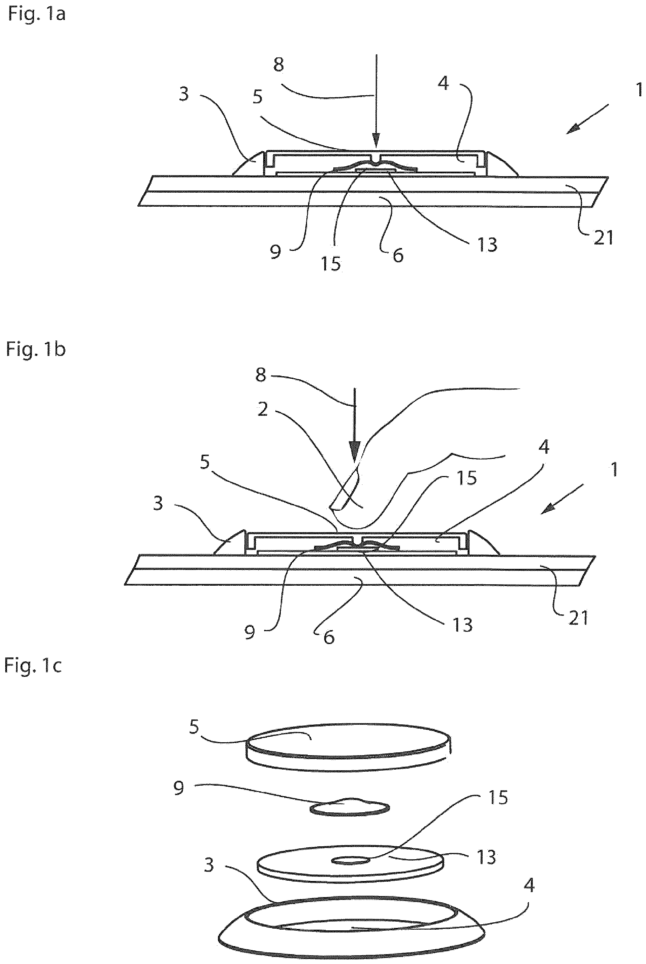

In Figur 1a ist eine Schalt-Vorrichtung 1 zur Umwandlung einer manuelle und/oder mechanischer Zustellbewegung in ein mehrstufiges Schaltsignal 10, 11, 12 durch die ein elektrisches Gerät gesteuert ist, zu entnehmen. Die Schalt-Vorrichtung 1 besteht aus einem Schaltgehäuse 3, in das eine Aufnahmeöffnung 4 eingearbeitet und dasaus einem elektrisch nicht-leitfähigen Werkstoff hergestellt ist. Das Schaltgehäuse 3 ist auf einer Abdeckplatte 21 angeordnet, angeklebt oder anderweitig fixiert und auf der dem Schaltgehäuse 3 abgewandten Seite der Abdeckplatte 21 ist ein kapazitiver Flächensensor 6 angeordnet, der ein räumlich wirkendes elektrisches Feld erzeugt und bei einer äußeren Beeinflussungen eine kapazitive Auswertung erlaubt. Eine Veränderung des elektrischen Feldes des kapazitiven Flächensensors 6, beispielsweise durch die Betätigung mittels eines Fingers, erzeugt dabei auswertbare elektrische Signaländerungen, durch die die Position des Fingers auf dem kapazitiven Flächensensor 6 bestimmbar ist.

Der kapazitive Flächensensor 6 kann aus einer Vielzahl von Elektrodenpaaren gebildet sein - jedoch aus mindestens einem Elektrodenpaar - die bei einer Bestromung das elektrische Feld erzeugen. Diese Elektrodenpaare können auch als eine Kondensatorschaltung beschrieben werden. Bei einer Störung des elektrischen Feldes des kapazitiven Flächensensors 6 durch einen Gegenstand 2 resultiert die auswertbare elektrische Signaländerung. Der Gegenstand 2 kann beispielsweise eine Hand, ein Finger oder ein vergleichbarer Gegenstand 2 sein, der Teile eines solchen kapazitiven Systems werden kann.

Bei einer Störung des elektrischen Feldes durch den Gegenstand 2, beispielsweise bei der Betätigung mittels eines Fingers, bewirken die betroffenen Elektroden folglich in dem kapazitiven Flächensensor 6 die Änderung des elektrischen Signals des kapazitiven Flächensensors 6. Diese auswertbare elektrische Signaländerung entspricht eines der Schaltsignale 10, 11, 12.

In der Aufnahmeöffnung 4 der Schalt-Vorrichtung 1 ist auf der der Abdeckplatte 21 abgewandten Seite eine Bedienkappe 5 entlang der Längsachse 8 beweglich gelagert. Die Bedienkappe 5 ist aus einem elektrisch leitfähigen Werkstoff hergestellt und ist federnd an einem leitfähigen Betätigungselement 9 abgestützt und mit diesem elektrisch verbunden. Das Betätigungselement 9 kann als eine Schnappscheibe ausgebildet sein und ist vorzugsweise aus einem metallischen Werkstoff hergestellt, so dass bei einer Berührung des Gegenstandes 2 mit der Bedienkappe 5 eine kapazitive Kopplung zwischen dem Gegenstand 2 und dem kapazitiven Flächensensor 6 mittels der Bedienkappe 5 und dem Betätigungselement 9 entsteht. Hierzu befindet sich das Betätigungselement 9 bereichsweise in dem elektrischen Feld des kapazitiven Flächensensors 6.

Das in diesem Ausführungsbeispiel als Schnappscheibe ausgebildete Betätigungselement 9 ist kuppelartig auf einem dünnwandigen elektrisch isolierenden Träger 13 abgestützt und in dem von dem Träger 13 und dem Betätigungselement 9 eingeschlossen Raum ist eine Kontaktplatte 15 angeordnet. Der Träger 13 kann aus einer Kunststofffolie hergestellt sein und lichtdurchlässig sein, dass dieser auch als Lichtleiter zur visuellen Wahrnehmung der Schalt-Vorrichtung 1 beitragen kann.

Die Kontaktplatte 15 ist in dem unbetätigten Zustand der Schalt-Vorrichtung 1 elektrisch isoliert und folglich beabstandet von der Bedienkappe 5 und von dem Betätigungselement 9 in dem Wirkbereich des elektrischen Feldes des Flächensensors 6 angeordnet.

Im betätigten Zustand, dargestellt in Figur 1b, der Schalt-Vorrichtung 1 ist die Bedienkappe 5 entlang der Längsachse 8 verschoben, durch die die Zustellrichtung definiert ist. Durch die elastischen Eigenschaften des Betätigungselementes 9 ist dieses derart verformt, dass eine elektrische Verbindung oder Koppelung zwischen der Bedienkappe 5 und der Kontaktplatte 15 entsteht. Die Kontaktplatte 15 vergrößert somit die elektrische Kopplung mit dem kapazitiven Flächensensor 6. Diese elektrische Kopplung in der zweiten Schaltstufe ist im Vergleich zu der elektrischen Kopplung in der ersten Schaltstufe, die ausschließlich durch das Betätigungselement 9 zustande kommt, größer und erzeugt somit unterschiedliche und damit differenzierbare Schaltsignale 10, 11. Der Gegenstand 2 ist nämlich einerseits im unbetätigten Zustand mit dem kapazitiven Flächensensor 6 und der Bedienkappe 5 und des Betätigungselementes 9 und andererseits im betätigten Zustand mittels der Bedienkappe 5, des Betätigungselementes 9 und der Kontaktplatte 15 elektrisch gekoppelt. Durch die elektrische Kopplung der Kontaktplatte 15 mit der Bedienkappe 5 beeinflusst die Kontaktplatte 15 das elektrische Feld des kapazitiven Flächensensors 6 und ein zweites Schaltsignal 11 wird dabei generiert. Dieses zweite Schaltsignal 11 ist von dem ersten Schaltsignal 10 differenzierbar.

Um eine gute Differenzierbarkeit der beiden elektrischen Schaltsignale 10, 11 zu erreichen, sind die effektiven Flächen in dem elektrischen Feld des kapazitiven Flächensensors 6 des Betätigungselements 9 und der Kontaktplatte 15 unterschiedlich groß bemessen. Aufgrund der unterschiedlich groß bemessenen effektiven Flächen des Betätigungselements 9 und der Kontaktplatte 15 wird das elektrische Feld des kapazitiven Flächensensors 6 mehr oder weniger stark beeinflusst und es können mehrere Schaltstufen realisiert werden.

Die taktile und akustische Rückmeldung der Schalt-Vorrichtung 1 ist durch die mechanischen Eigenschaften des Betätigungselements 9 erreicht, das nämlich als Schnappscheibe ausgestaltet ist. In der ersten Schaltstufe der Schalt-Vorrichtung 1 befindet sich die Schnappscheibe im statisch stabilen Zustand. Das Schaltsignal 10 wird bei der Berührung der Bedienkappe 5 erzeugt. Beim Drücken oder Zuschalten der Bedienkappe 5 ist die Schnappscheibe schlagartig in ihren betätigten Zustand überführt und erzeugt eine taktil und akustisch wahrnehmbare Rückmeldung bei dem Erreichen der zweiten Schaltstufe. Diese schlagartige Verformung des Betätigungselementes 9 in Richtung des kapazitiven Flächensensors 6 erzeugt den elektrischen Kurzschluss zwischen dem Betätigungselement 9 und der Kontaktplatte 15. Nach der Betätigung und dem Loslassen der Bedienkappe 5 ist diese durch die Vorspannung des Betätigungselementes 9 in die Ausgangsposition zurückgeführt.

Die einzelnen Komponenten der Schalt-Vorrichtung 1 sind insbesondere der Explosionszeichnung in Figur 1c zu entnehmen,

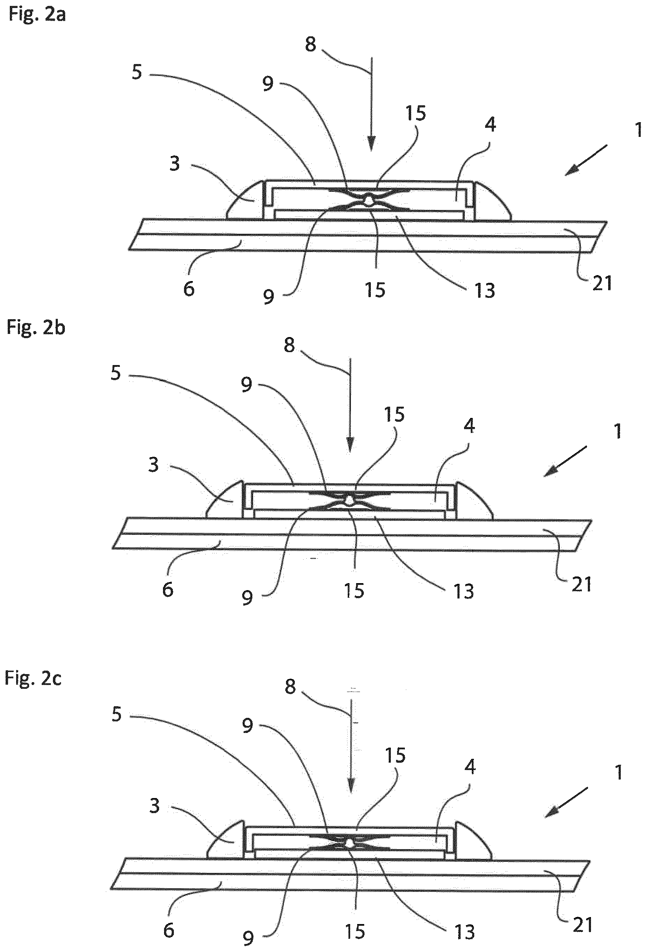

In den Figuren 2a bis 2c ist eine Schalt-Vorrichtung 1 mit drei Schaltstufen dargestellt. Die drei Schaltstufen der Schalt-Vorrichtung 1 werden durch eine Art Reihenschaltung von zwei als Schnappscheibe ausgebildeten Betätigungselementen 9 bewerkstelligt, die unterschiedliche mechanische Eigenschaften aufweisen, so dass diese sequenziell - also zeitlich nacheinander - beim Betätigen der Schalt-Vorrichtung 1 in Abhängigkeit von dem Hub der Bedienkappe 5 eine wahrnehmbare Rückmeldung geben.

Die beiden Betätigungselemente 9 sind aus einem elektrisch leitfähigen Material hergestellt. Die kuppelförmigen als Schnappscheibe ausgebildeten Betätigungselemente 9 sind spiegelsymmetrisch zueinander angeordnet und elektrisch miteinander verbunden. In den durch die kuppelform der Betätigungselemente 9 gebildeten Hohlräume sind jeweils eine Kontaktplatte 15 angeordnet, die in dem unverformten Zustand des jeweiligen Betätigungselements 9 zu diesem elektrisch isoliert angeordnet sind.

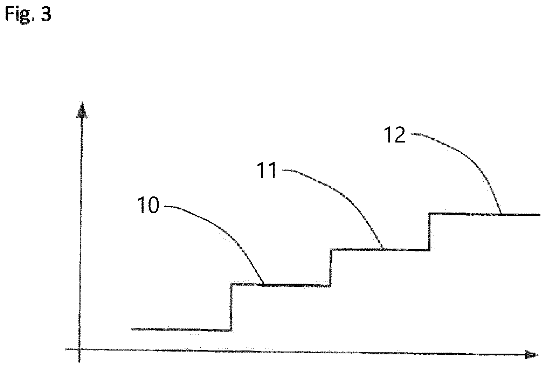

Das erste Schaltsignal 10 ist analog zu den bereits vorgestellten Ausführungsbeispielen bei der Berührung der Bedienkappe 5 mit dem Gegenstand 2 erzeugt. Die kapazitive Kopplung des kapazitiven Flächensensors 6 mit dem Gegenstand 2 erfolgt dabei durch die Bedienkappe 5 und den Betätigungselementen 9. Das zweite Schaltsignal 11 ist bei einer manuellen Betätigung der Bedienkappe 5 und einem vorgegebenen Hub generiert. Aufgrund der Zustellbewegung ist zunächst eines der Betätigungselemente 9 schlagartig in den betätigten Zustand überführt und eine nach Art einer Parallelschaltung ist eine kapazitive Kopplung zwischen dem Betätigungselement 9 und der Kontaktplatte 15 hergestellt, die zu einer elektrisch erfassbaren Änderung des elektrischen Feldes des kapazitiven Flächensensors 6 führt. Ein drittes Schaltsignal 12 ist bei einer weiteren-Zustellbewegung der Bedienkappe 5 generiert, wenn auch das zweite Betätigungselement 9 in den betätigten Zustand überführt ist. Dieser Zustand entspricht der dritten Schaltstufe, dargestellt in Figur 3c. Diese Schaltstufe wird analog zur zweiten Schaltstufe mittels der unter dem zweiten Betätigungselement 9 angeordneten zweiten Kontaktplatte 15 hergestellt. Diese Änderung in dem elektrischen Feld des kapazitiven Flächensensors 6 ist durch diesen erfasst und ein drittes Schaltsignal 12 ist generiert.

Durch die elektrischen Eigenschaften der Betätigungselemente 9 und der Kontaktplatten 15 sowie der Anordnung der Betätigungselemente 9 und der Kontaktplatten 15 ist erreicht, dass das elektrische Feld des kapazitive Flächensensors 6 unterschiedlich beeinflusst ist.

Ein Signalverlauf einer dreistufigen Schalt-Vorrichtung 1 ist der Figur 3 zu entnehmen. Es ist ersichtlich, dass die Schaltsignale 10, 11, unterschiedliche Signalwerte aufweisen und der Signalverlauf zwischen den Schaltsignalen 10, 11, 12 sprungartig verläuft. Dieser scharfkantige und sprungartige Signalverlauf ist dadurch erreicht, dass die jeweilige Kontaktplatte 15 zunächst elektrisch abschirmende Eigenschaften aufweist und schlagartig bei einem Kurzschluss mit dem Betätigungselement 9 die die kapazitive Kopplung mit dem kapazitiven Flächensensor 6 verändert. Dieser scharfkantige Spannungsverlauf ist insbesondere vorteilhaft, um eine gute Differenzierbarkeit zwischen den Schaltsignalen 10, 11, 12 zu erreichen.

## Patentansprüche

1. Schalt-Vorrichtung (1) zur Umwandlung einer manuellen und/oder mechanischen Zustellbewegung in mindestens ein Schaltsignal (10), durch die ein elektrisches Gerät gesteuert ist, bestehend aus:
- einem Schaltgehäuse (3), in das eine Aufnahmeöffnung (4) eingearbeitet ist,
- einer Bedienkappe (5), die aus einem elektrisch leitfähigen Werkstoff hergestellt und an oder in der Aufnahmeöffnung (4) des Schaltgehäuses (5) entlang einer Zustellrichtung (8) beweglich gelagert ist,
- einem kapazitiven Flächensensor (6), der zur kapazitiven Auswertung ein räumlich wirkendes elektrisches Feld erzeugt und der auf der in Zustellrichtung (8) gegenüberliegenden Seite der Bedienkappe (5) in oder außerhalb des Schaltgehäuses (3) angeordnet ist und bei einer Änderung des elektrischen Feldes ein Schaltsignal (10) generiert, und
- mindestens einem zwischen der Bedienkappe (5) und dem kapazitiven Flächensensor (6) vorgesehenen Betätigungselement (9), das elektrisch leitfähig und elastisch verformbar ist, durch das mindestens eine kapazitive Kopplung zwischen der Bedienkappe (5) und dem kapazitiven Flächensensor (6) entsteht, wobei die Schalt-Vorrichtung derart ausgestaltet ist,
- dass durch das Betätigungselement (9) das erste elektrische Schaltsignal (10) bei einer Berührung der Bedienkappe (5) mithilfe des kapazitiven Flächensensors (6) generiert ist und
- dass bei einer Zustellbewegung der Bedienkappe (5) mindestens ein zweites differenzierbares elektrisches Schaltsignal (11, 12) mithilfe des kapazitiven Flächensensors (6) gebildet ist, **dadurch gekennzeichnet,**
- **dass** zwischen der Bedienkappe (5) und dem kapazitiven Flächensensor (6) mindestens eine elektrisch leifähige Kontaktplatte (15) angeordnet ist, die elektrisch isoliert von dem Betätigungselement ist, dass bei einer Zustellbewegung der Bedienkappe (5) diese mit mindestens einer der Kontaktplatten (15) kurzgeschlossen ist und dass die Bedienkappe (5) mittels der jeweiligen Kontaktplatte (15) mit dem kapazitiven Flächensensor (6) kapazitiv gekoppelt ist.

2. Schalt-Vorrichtung nach Anspruch 1,
**dadurch gekennzeichnet,**
**dass** das Betätigungselement (9) und/oder die Kontaktplatte (15) auf einem dünnwandigen elektrisch isolierenden Träger (13) angeordnet ist.

3. Schalt-Vorrichtung (1) nach einem der Ansprüche 1 bis 2,
**dadurch gekennzeichnet,**
**dass** der kapazitive Flächensensor (6) mindestens als kapazitiver Einzelsensor, vorzugsweise als Button, oder aus einem Elektrodenpaaren gebildet ist und dass die Schaltsignale (10, 11, 12) in Abhängigkeit und/oder der Intensität des oder der beeinflussten Elektrodenpaaren bzw. des Einzelsensors generiert sind.

4. Schalt-Vorrichtung (1) nach einem der Ansprüche 1 bis 3,
**dadurch gekennzeichnet,**
**dass** die Werte der Schaltsignale (11, 12, 13) abhängig von dem Abstand zwischen der Bedienkappe (5) und/oder des Bedienungselementes (9) und dem kapazitiven Flächensensor (6) ist.

5. Schalt-Vorrichtung nach Anspruch 2,
**dadurch gekennzeichnet,**
**dass** der Träger (13) aus einem lichtdurchlässigen elektrisch isolierenden Werkstoff hergestellt ist.

6. Schalt-Vorrichtung (1) nach einem der vorgenannten Ansprüche,
**dadurch gekennzeichnet,**
**dass** das Betätigungselement (9) als Schnappscheibe ausgebildet ist, die mindestens einen statisch stabilen und einen statisch instabilen Zustand aufweist.

7. Schalt-Vorrichtung (1) nach einem der vorgenannten Ansprüche,
**dadurch gekennzeichnet,**
**dass** das Schaltgehäuse (3) auf einer Abdeckplatte (21) eines Touchscreens oder eines anderen kapazitiven Flächensensors befestigt ist, und dass in dem Touchscreen der kapazitive Flächensensor (6) angeordnet ist.

8. Schalt-Vorrichtung (1) nach einem der vorgenannten Ansprüche,
**dadurch gekennzeichnet,**
**dass** der Flächensensor (6) auf einem oberflächen-kapazitiven, projiziertkapazitiven, induktiven Dispersive-Signal-Technology oder einer Kombination dieser Verfahren basiert.

## Claims

1. A switching device (1) for converting a manual and/or mechanical feed movement into at least one switching signal (10), by means of which an electrical device is controlled, comprising:
- a switch housing (3), into which a receiving opening (4) is incorporated,
- an operating cap (5) made of an electrically conductive material and being movably supported at or in the receiving opening (4) of the switch housing (5) along a feed direction (8),
- a capacitive surface sensor (6) which generates a spatially acting electrical field for capacitive evaluation and which is arranged on the opposite side of the operating cap (5) in the feed direction (8) within or beyond the switch housing (3) and which generates a switching signal (10) in the case of a change of the electrical field, and
- at least one actuator element (9) provided between the operating cap (5) and the capacitive surface sensor (6), which is electrically conductive and elastically deformable, by means of which at least one capacitive coupling is generated between the operating cap (5) and the capacitive surface sensor (6),
wherein the switching device is designed in such a way
- that by means of the actuator element (9) the first electrical switching signal (10) is generated upon touching the operating cap (5) by means of the capacitive surface sensor (6), and
- that upon a feed movement of the operating cap (5) at least one second differentiable electrical switching signal (11, 12) is generated by means of the capacitive surface sensor (6),
**characterized in that**
between the operating cap (5) and the capacitive surface sensor (6) at least one electrically conductive contact plate (15) is arranged, which is electrically isolated from the actuator element, that upon a feed movement of the operating cap (5), the same is short-circuited with at least one of the contact plates (15) and that the operating cap (5) is capacitively coupled with the capacitive surface sensor (6) by means of the respective contact plate (15).

2. The switching device according to claim 1,
**characterized in that**
the actuator element (9) and/or the contact plate (15) is disposed on a thin-walled electrically isolating carrier (13).

3. The switching device (1) according to any of claims 1 to 2,
**characterized in that**
the capacitive surface sensor (6) is at least configured to be a capacitive single sensor, preferably a button, or a pair of electrodes, and that the switching signals (10, 11, 12) are generated dependent on and/or the intensity of the affected pair(s) of electrodes or the single sensor, respectively.

4. The switching device (1) according to any of claims 1 to 3,
**characterized in that**
the values of the switching signals (11, 12, 13) depend on the distance between the operating cap (5) and/or the actuator element (9) and the capacitive surface sensor (6).

5. The switching device according to claim 2,
**characterized in that**
the carrier (13) is made from a translucent electrically isolating material.

6. The switching device (1) according to any of the foregoing claims,
**characterized in that**
the actuator element (9) is configured as a snap dome having at least one statically stable and one statically instable state.

7. The switching device (1) according to any of the foregoing claims,
**characterized in that**
the switch housing (3) is mounted on a cover plate (21) of a touchscreen or of any other capacitive surface sensor and **in that** the capacitive surface sensor (6) is disposed in the touchscreen.

8. The switching device (1) according to any of the foregoing claims,
**characterized in that**
the surface sensor (6) is based on a surface-capacitive, projected-capacitive, inductive disperse-signal technology or a combination of these methods.

## Revendications

1. Dispositif de commutation (1) servant à la transformation d'un mouvement d'avance manuel et/ou mécanique en au moins un signal de commutation (10) pour l'activation d'un appareil électrique, comprenant :
- un boîtier de commutation (3) dans lequel il est pratiqué une ouverture de réception (4),
- un capot d'actionnement (5) réalisé en matériau électriquement conducteur qui est monté de manière mobile le long d'un équipement d'avance (8) sur ou dans l'ouverture de réception (4) du boîtier de commutation (3),
- un capteur de surface capacitif (6) qui, en vue de l'évaluation capacitive, génère un champ électrique à effet spatiale, et qui est disposé dans ou à l'extérieur du boîtier de commutation (3) sur le côté du capot d'actionnement (5) opposé au sens d'avance (8), et qui, en cas de changement du champ électrique, génère en signal de commutation (10), et
- au moins un élément d'actionnement électriquement conducteur et déformable (9), prévu entre le capot d'actionnement (5) et le capteur de surface capacitif (6), et qui produit au moins un couplage capacitif entre le capot d'actionnement (5) et le capteur de surface capacitif (6),
l'élément d'actionnement (9) étant conçu de sorte que,
- au contact du capot d'actionnement (5), à l'aide du capteur de surface capacitif (6), l'élément d'actionnement (9) génère le premier signal de commutation électrique (10) et que
- en cas de mouvement d'avance du capot d'actionnement (5), à l'aide du capteur de surface capacitif (6), il est généré au moins un deuxième signal de commutation électrique différentiable (11, 12),
**caractérisé en ce que**,
- entre le capot d'actionnement (5) et le capteur de surface capacitif (6), il est monté au moins une plaque de contact électriquement conductrice (15), qui est électriquement isolée de l'élément d'actionnement, que, au mouvement d'avance du capot d'actionnement (5), celui-ci est court-circuité avec au moins une des plaques de contact (15) et que, moyennant la plaque de contact respective (15), le capot d'actionnement (5) est couplé de manière capacitive au capteur de surface capacitif (6).

2. Dispositif de commutation d'après la revendication 1,
**caractérisé en ce que**
l'élément d'actionnement (9) et/ou la plaque de contact (15) sont arrangés sur un support à paroi mince et électriquement isolant (13).

3. Dispositif (1) de commutation d'après une des revendications 1 ou 2,
**caractérisé en ce que**
le capteur de surface capacitif (6) est conçu au moins sous la forme d'un capteur individuel, de préférence un bouton, ou d'une paire d'électrodes et que les signaux de commutation (10, 11, 12) sont générés en dépendance de l'intensité de la ou des paires d'électrodes influencées ou du capteur individuel.

4. Dispositif (1) de commutation d'après une des revendications 1 à 3,
**caractérisé en ce que**
les valeurs des signaux de commutation (11, 12, 13) dépendent de la distance entre le capot d'actionnement (5) et/ou de l'élément d'actionnement (9) et le capteur de surface capacitif (6).

5. Dispositif de commutation d'après la revendication 2,
**caractérisé en ce que**
le support (13) est réalisé en matériau transparent et électriquement isolant.

6. Dispositif (1) de commutation d'après une des revendications précédentes
**caractérisé en ce que**
l'élément d'actionnement (9) est conçu sous la forme d'un disque à déclic possédant au moins un état statiquement stable et un état statiquement instable.

7. Dispositif (1) de commutation d'après une des revendications précédentes
**caractérisé en ce que**
le boîtier de commutation (3) est fixé sur une plaque de recouvrement (21) d'un écran tactile ou d'un autre capteur de surface capacitif et que le capteur de surface capacitif (6) est arrangé dans l'écran tactile.

8. Dispositif (1) de commutation d'après une des revendications précédentes
**caractérisé en ce que**
le capteur de surface (6) se base sur une technologie de signal capacitive superficielle, capacitive projetée, capacitive projetée, inductive dispersive ou sur une combinaison de ces procédés.
